(19) **Europäisches Patentamt**
**European Patent Office**
**Office européen des brevets**

(11) **EP 3 203 527 B1**

(12) **FASCICULE DE BREVET EUROPEEN**

(45) Date de publication et mention
de la délivrance du brevet:
**24.12.2025 Bulletin 2025/52**

(21) Numéro de dépôt: **17154327.5**

(22) Date de dépôt: **02.02.2017**

(51) Classification Internationale des Brevets (IPC):
**H10D 30/47** (2025.01) **H10D 62/17** (2025.01)
**H10D 64/27** (2025.01) **H10D 62/854** (2025.01)
**H10D 62/85** (2025.01)

(52) Classification Coopérative des Brevets (CPC):
**H10D 30/475; H10D 62/371; H10D 62/8503;
H10D 62/854; H10D 64/513**

(54) **TRANSISTOR A HETEROJONCTION A HAUTE MOBILITE ELECTRONIQUE DE TYPE NORMALEMENT BLOQUE**

SELBSTSPERRENDER TRANSISTOR MIT HETEROÜBERGANG MIT HOHER
ELEKTRONENBEWEGLICHKEIT

HETEROJUNCTION TRANSISTOR HAVING HIGH ELECTRON MOBILITY OF THE
NORMALLY-OFF TYPE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **04.02.2016 FR 1650901**

(43) Date de publication de la demande:
**09.08.2017 Bulletin 2017/32**

(73) Titulaire: **Commissariat à l'Energie Atomique et
aux Energies
Alternatives
75015 Paris (FR)**

(72) Inventeur: **MORVAN, Erwan
38160 Montagne (FR)**

(74) Mandataire: **INNOV-GROUP
209 Avenue Berthelot
69007 Lyon (FR)**

(56) Documents cités:
**WO-A1-2015/159499     US-A1- 2011 068 371**

• **WANG MAOJUN ET AL: "Normally-off hybrid
Al2O3/GaN MOSFET on silicon substrate based
on wet-etching", 2013 25TH INTERNATIONAL
SYMPOSIUM ON POWER SEMICONDUCTOR
DEVICES & IC'S (ISPSD), IEEE, 15 June 2014
(2014-06-15), pages 253 - 256, XP032620486,
ISSN: 1943-653X, ISBN: 978-1-4673-5134-8,
[retrieved on 20140714], DOI: 10.1109/
ISPSD.2014.6856024**

**Description**

**L'invention concerne les transistors à haute mobilité électronique basés sur la présence d'hétérojonctions, et en particulier** les transistors HEMT de type normalement bloqué.

De nombreuses applications électroniques nécessitent dorénavant une amélioration de performances surtout dans l'électronique embarquée à destination de l'automobile et des transports terrestres, dans l'aéronautique, dans les systèmes médicaux ou dans des solutions domotiques par exemple. Ces applications nécessitent pour la plupart des commutateurs pour forte puissance fonctionnant dans des gammes de fréquences fréquemment supérieures au megahertz.

Historiquement, des commutateurs de puissance ont longtemps fait appel à des transistors à effet de champ basés sur un canal semi-conducteur, le plus souvent du silicium. Pour des fréquences plus faibles, les transistors à jonction sont préférés car ils supportent des densités de courant plus élevées. Cependant, du fait de la tension de claquage relativement limitée de chacun de ces transistors, les applications de puissance nécessitent l'utilisation d'un grand nombre de transistors en série, ou des transistors plus longs, ce qui aboutit à une résistance de passage plus élevée. Les pertes à travers ces transistors en série sont considérables, **aussi bien en régime établi qu'en commutation.**

Une alternative pour des commutateurs de puissance, notamment à hautes fréquences, est l'utilisation de transistors à effet de champ à haute mobilité d'électrons, également désignés par le terme de transistor à effet de champ à hétérostructure. Un tel transistor inclut la superposition de deux couches semiconductrices ayant des bandes interdites différentes et présentent une polarisation qui conduit à la formation d'un gaz bidimensionnel **d'électrons** à forte mobilité et à forte densité. Pour des raisons de tenue en haute tension et en température, ces transistors sont **fabriqués à l'aide de matériaux semiconducteur** de type III-N, à large bande interdite.

Pour certaines applications, notamment des applications de sécurité en **vue d'isoler un circuit en cas de dysfonctionnement d'un système de commande,** on utilise des transistors HEMT du type normalement bloqué, c'est-à-dire que leur tension de seuil de commutation vers **l'état passant** est positive, de sorte que le transistor reste bloqué en l'absence de signal de commande.

Du fait de la nature intrinsèquement conductrice de la couche de gaz d'électrons formée entre une source et un drain, il est technologiquement plus facile de réaliser un transistor à hétérojonction de type normalement passant. Cependant, plusieurs procédés de fabrication ont été développés en vue de former des transistors à hétérojonction de type normalement ouvert ou normalement bloqué.

Il est connu de réaliser des grilles de commande de type Schottky pour des transistors à hétérojonction de type normalement bloqué. Cependant, de tels transistors sont inadaptés pour de l'électronique de puissance du fait des niveaux de fuite en courant entre grille et drain et du fait de la sensibilité de la courbe courant/tension à la température. Différents procédés de fabrication ont aussi été développés pour réaliser des grilles de type MIS pour des transistors à heterojonction de type normalement bloqué. Cette structure permet aussi de **piloter la grille en positif et en négatif pour rester compatible avec l'électronique** de commande utilisée pour les composants de puissance en Silicium.

Selon une approche, on superpose une couche binaire de nitrure de type III et une couche ternaire de nitrure de type III pour former une couche de gaz **d'électrons à l'interface** entre ces nitrures. On réalise un renfoncement par gravure dans la couche ternaire de nitrure afin de réduire localement l'épaisseur de cette couche ternaire. Lorsque l'épaisseur locale de la couche ternaire de nitrure est suffisamment faible, par exemple de 2 à 3 nm pour du AlGaN, le gaz d'électrons disparaît au niveau du renfoncement. Ensuite, on forme la grille au niveau du renfoncement.

Le processus de gravure du renfoncement est encore insuffisamment maîtrisé pour garantir une épaisseur satisfaisante de la couche ternaire de nitrure dans le renfoncement.

Selon une alternative **décrite notamment dans le document 'over 100A** operation normally-off AlGaN/GaN hybrid MOS-HFET on Si substrate with high-**breakdown voltage' par** Hiroshi Kambayashi et al., publié dans 'Solid-State Electronics', Volume 54, numéro 6, en Juin 2010, Pages 660-664, on réalise la gravure jusqu'à la couche binaire de nitrure. **Une telle structure permet d'obtenir** une tension de seuil supérieure à 3V. Une telle structure a par contre comme inconvénient d'avoir localement un fonctionnement de type MOSFET avec une densité et surtout une mobilité de charges dégradées, et donc une résistance à l'état passant relevée.

Le document US2011/068371 décrit un transistor à effet de champ à haute mobilité électronique, comprenant notamment :

- une première couche de GaN;
- une deuxième couche de GaN à dopage de type P formée sur la première couche de GaN;
- une troisième couche de GaN à dopage de type N formée sur la deuxième couche de GaN de façon à former une jonction p/n déplétée.

**Ce document ne permet pas d'assurer la déplétion complète de la couche** de GaN à dopage de type P et ne permet pas une bonne tenue en tension et l'obtention d'une barrière électrique suffisante. Par ailleurs, ce document pose des problèmes de diffusion des dopants vers la couche de gaz d'électrons, avec un important effet électrique de ces dopants sur la couche de gaz d'électrons.

Le document 'Normally-Off Al2O3/GaN MOSFET on Silicon Substrate based on Wet-Etching', publié par Mrs Wang et alias aux pages 253-256 des présentations divulguées dans le cadre du 26ème Symposium International Power Semiconductor Devices & IC's qui s'est tenu du 15 au 19 Juin 2014 à Hawaï, décrit un transistor MOSFET fabriqué sur un substrat de Silicium. Le fonctionnement en normalement ouvert est obtenu par un renfoncement de grille utilisant une oxydation et une gravure humide pour le retrait d'une barrière AlGaN.

L'invention vise à résoudre un ou plusieurs de ces inconvénients. L'invention porte ainsi sur un transistor à hétérojonction à haute mobilité électronique, tel que défini dans la revendication 1.

L'invention porte également sur les variantes des revendications annexées. L'homme du métier comprendra que chacune des caractéristiques des variantes des revendications dépendantes peut être combinée indépendamment aux caractéristiques ci-dessus, sans pour autant constituer une généralisation intermédiaire.

D'autres caractéristiques et avantages de l'invention ressortiront clairement de la description qui en est faite ci-après, à titre indicatif et nullement limitatif, en référence aux dessins annexés, dans lesquels :

- la figure 1 est une vue en coupe d'un exemple de transistor à hétérojonction à haute mobilité électronique selon l'invention ;
- les figures 2 et 3 sont des diagrammes de bandes de conduction d'un transistor selon l'invention et d'un transistor selon l'état de la technique ;
- la figure 4 est un diagramme illustrant une densité d'électron, une bande de conduction et une bande de valence sous la grille d'un exemple de transistor selon l'invention ;
- la figure 5 est une vue en coupe d'une variante d'un transistor selon l'invention ;
- la figure 6 est une vue en coupe d'une structure cascode incluant un transistor selon l'invention ;
- la figure 7 est un schéma électrique équivalent de la structure cascode de la figure 6 ;
- les figures 8 et 9 illustrent des valeurs d'épaisseurs de certaines couches en fonction de leurs concentrations en dopants.

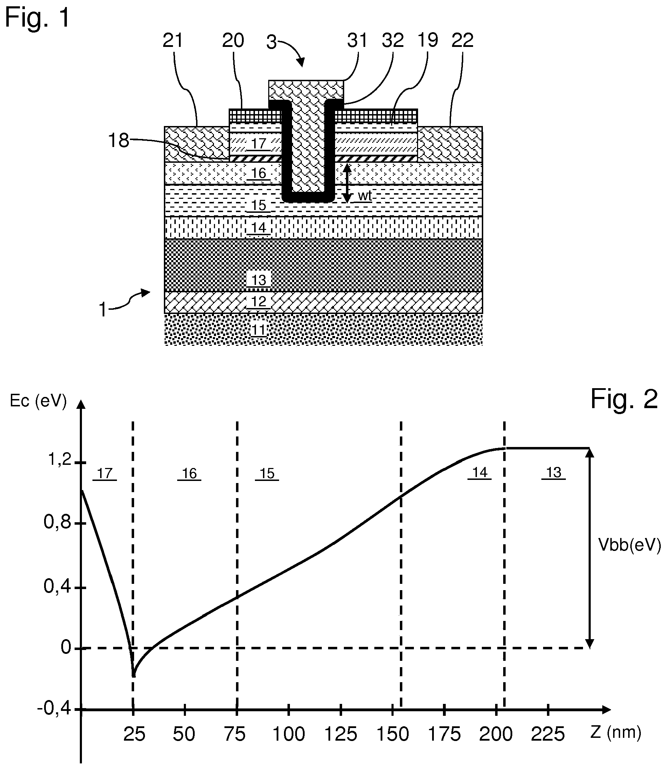

La figure 1 est une vue en coupe schématique d'un exemple de transistor à hétérojonction à haute mobilité électronique de type normalement bloqué, selon un mode de réalisation de l'invention. Le transistor 1 comporte un substrat 11, une couche de nucléation 12 disposée sur le substrat 11, une couche tampon de GaN 13 disposée sur la couche de nucléation 12, une couche de GaN dopée P 14 disposée sur la couche tampon de GaN 13, une couche de GaN dopée N 15 disposée sur la couche de GaN 14, et une couche de GaN non intentionnellement dopée 16 disposée sur la couche 15. Le transistor 1 comprend en outre une couche d'AlGaN 17 disposée sur la couche 16. Un gaz d'électrons est intrinsèquement formé par hétérojonction à l'interface entre la couche 17 et la couche 16. Dans un souci de lisibilité, le gaz d'électrons est illustré sous forme de couche 18 à l'interface entre la couche 16 et la couche 17. Une couche intermédiaire non illustrée peut être interposée entre les couches 16 et 17, par exemple pour accroître la densité d'électrons dans le gaz d'électrons et améliorer le confinement des électrons dans le GaN. Une telle couche intermédiaire est typiquement extrêmement fine (par exemple 1nm) et peut être réalisée en AlN (particulièrement adapté à l'interface entre une couche 16 en GaN et une couche 17 en AlGaN).

Selon l'invention, la couche 14 inclut du Magnésium formant un dopant de type P, la concentration en magnésium activé dans cette couche de GaN 14 étant au moins égale à $1 * 10^{17}$ cm$^{-3}$ et au plus égale à $1 * 10^{18}$ cm$^{-3}$, cette couche de GaN 14 présentant une épaisseur comprise entre 10 et 50 nm.

Avec une telle configuration selon l'invention, on peut obtenir une déplétion complète de la couche 14, et une absence de diffusion du Magnésium jusqu'à la couche de gaz d'électrons 18. Une telle absence de diffusion du Magnésium jusqu'à la couche de gaz d'électrons 18 évite des effets électriques néfastes sur celle-ci, en particulier pour une valeur élevée du potentiel de diffusion de la jonction P/N formée à l'interface entre les couches 14 et 15.

Dans l'exemple illustré à la figure 1, le transistor 1 comporte avantageusement une couche 19 de GaN formée de façon connue en soi sur la couche 17. La couche 19 permet d'éviter une oxydation de la couche 17 en AlGaN dans le présent exemple. La couche 19 présente par exemple une épaisseur comprise entre 1 et 3nm. La couche 19 est avantageusement recouverte d'une couche de passivation 20, par exemple en oxyde de Silicium ou en nitrure de silicium.

On peut aussi avoir une couche 20 en nitrure de Silicium sur la couche 17, en remplacement de la couche 19, déposée in-situ dans le bâti utilisé pour les étapes d'épitaxie, afin d'avoir une interface SiN/AlGaN et une couche SiN de très bonne qualité.

De façon connue en soi, le transistor 1 comporte une source 21, un drain 22 et une grille de commande 3. La source 21 et le drain 22 sont formés sur la couche d'AlGaN 17 et présentent une caractéristique électrique courant-tension linéaire (ohmique). La résistance de contact source 21/couche de gaz d'électrons 18 et la résistance de contact drain 22/couche de gaz d'électrons 18 sont faibles et typiquement comprises entre 0.5 et 1 Ohm.mm. La source 21, le drain 22 et la grille de commande 3 sont illustrés uniquement schématiquement, leurs dimensions et leurs structures pouvant différer fortement de l'illustration de la figure 1.

Une cavité est formée à travers la couche d'AlGaN 17 et à travers la couche de GaN 16. La cavité s'étend jusque dans la couche de GaN 15 mais sans la traverser. Du GaN dopé N délimite ainsi le fond de cette cavité. Dans le présent exemple, la cavité traverse également les couches 19 et 20.

La grille de commande 3 inclut une couche d'isolant de grille 32 et un matériau de grille conducteur 31 (dont le travail de sortie est avantageusement élevé). L'isolant de grille 32 isole électriquement le conducteur de grille 31 par rapport aux couches 15, 16 et 17 notamment. L'isolant de grille 32 recouvre ici le fond et les parois latérales de la cavité. L'isolant de grille 32 est ainsi en contact avec la couche 15 dans le fond de la cavité, et en contact avec les couches 15, 16 et 17 au niveau des parois latérales de la cavité. L'isolant de grille 31 peut par exemple être réalisé en $Al_2O_3$.

Le matériau de grille 31 est disposé dans la cavité, dans un espace non occupé par l'isolant de grille 32. Le matériau de grille est séparé des couches 15, 16 et 17 par l'intermédiaire de l'isolant de grille 32. Le matériau de grille 31 est en contact avec l'isolant de grille 32. Le matériau de grille 31 est par exemple du métal, incluant par exemple du TiN, du W, ou du Ni (métaux à travail de sortie élevé).

On désignera par la suite le canal comme la zone de la couche de GaN 15 dans laquelle la conduction est commandée par la grille 3. Les accès du transistor 1 incluent les zones entre grille de commande 3 et drain 22, et entre grille de commande 3 et source 21, en incluant la couche de gaz d'électrons 18. Le **transistor 1 selon l'invention vise à assurer une conduction par gaz d'électrons au** niveau des accès et un fonctionnement de type transistor à effet de champ à accumulation au niveau du canal.

La superposition de la couche de GaN dopée P 14 à la couche de GaN dopée N 15 permet de former une jonction P/N déplétée, de façon à former une barrière de potentiel particulièrement élevée sous la couche de gaz d'électrons. Ainsi, au niveau des accès, la jonction formée permet de confiner les électrons dans la couche 16 et ainsi éviter leur piégeage dans des couches inférieures, notamment la couche 13 qui peut comporter un grand nombre de pièges du fait **d'une potentielle forte concentration en carbone.**

La jonction P/N formée peut être complètement déplétée avec des épaisseurs et concentrations en dopants appropriées dans les couches 14 et 15. En outre, une telle jonction est formée avec des matériaux compatibles avec la couche de GaN 16 non intentionnellement dopée destinée à former la couche de **gaz d'électrons. Une telle jonction peut être obtenue dès une formation par** épitaxie des couches 14 et 15.

La couche dopée N 15 permet de séparer la conception des accès et du canal. La couche 15 absorbe le potentiel Vbi (détaillé par la suite) au niveau des **accès, et permet la fabrication du canal indépendamment du gaz d'électrons** 18.

En outre, une telle barrière de potentiel permet d'éviter la formation d'une couche d'AlGaN sous cette couche de GaN non intentionnellement dopée 16, ce qui permet de limiter les contraintes mécaniques à l'interface avec cette couche de GaN 16.

Par ailleurs, sous la grille 3, on bénéficie de la déplétion du GaN dopé N du canal, ce qui permet de former un transistor de type normalement bloqué avec une tension de seuil élevée, aisément supérieure à 3V. Comme détaillé par la **suite, le GaN dopé N du canal est déplété sous l'action du GaN dopé P et du** matériau de grille conducteur 31. Pour rendre le canal conducteur, il faut **accumuler suffisamment d'électrons dans le canal sous la grille 3, par l'intermédiaire d'une différence de potentiel entre source et grille supérieure à la** tension de seuil. Comme détaillé par la suite, la tension de seuil Vth du transistor 1 peut être ajustée en jouant notamment sur différents paramètres technologiques.

**A l'état passant, la densité d'électrons et leur mobilité est supérieure à celles obtenues pour un canal d'inversion.** Par ailleurs, en dissociant le canal et les accès, on évite de détériorer **les performances du transistor 1 à l'état passant.**

Le substrat 11 peut être un isolant ou un semi-conducteur de type silicium intrinsèque ou dopé, du SiC ou du saphir ($Al_2O_3$ monocristallin). Le substrat 11 peut typiquement présenter une épaisseur de l'ordre de 500 $\mu$m à 1mm.

La couche de nucléation 12 déposée sur le substrat 11 sert d'intermédiaire entre ce substrat et la couche tampon 13 de GaN, pour favoriser une croissance **par épitaxie de la couche tampon 13. Une telle couche de nucléation 12 s'avère** particulièrement avantageuse en cas de forte inadaptation de paramètres de maille **et de CTE (coefficients** d'expansion thermique ou de dilatation) entre la couche 13 et le substrat 11, qui pourrait aboutir à une impossibilité de réaliser l'hétérostructure avec une qualité suffisante pour fabriquer les composants. La couche de nucléation 12 est par exemple en AIN. La couche de nucléation 12 présente par exemple une épaisseur de 100nm.

La couche de GaN 13 est par exemple enrichie en carbone en vue d'augmenter sa résistivité électrique. Un enrichissement en carbone peut par exemple être réalisé simultanément à une croissance par épitaxie de la couche 13. La couche 13 présente typiquement une épaisseur de 1 à 15$\mu$m en fonction de la gamme de tension visée pour le composant de transistor 1.

La couche de GaN dopée P 14 présente une épaisseur comprise entre 10 et 50 nm et une concentration en dopants P de $1 * 10^{17}$ cm$^{-3}$ à $1 * 10^{18}$ cm$^{-3}$. La couche de GaN dopée N 15 présente par exemple une épaisseur de 80 nm et une concentration en dopants N de $2 * 10^{16}$ à $2 * 10^{17}$cm$^{-3}$. Les couches 14 et 15 présentent une concentration en carbone inférieure à celle de la couche 13. Cette concentration est par exemple de l'ordre de $10^{16}$cm$^{-3}$.

La couche de GaN non intentionnellement dopée 16 présente par exemple une épaisseur de 50 nm. Afin de favoriser une mobilité d'électrons maximale dans la couche de gaz d'électrons 18, la couche de GaN 16 présente un dopage le plus réduit possible. On considérera par exemple qu'une couche 16 est non intentionnellement dopée si la concentration en dopants N et P est inférieure à 1 * 10$^{16}$ cm$^{-3}$. Un autre critère pour la couche non intentionnellement dopée est que sa concentration en dopants N et P est inférieure à la concentration en dopants dopés N de la couche 15. La couche d'AlGaN 17 présente par exemple une épaisseur de 25 nm.

Dans l'exemple illustré, la couche barrière 17 est formée en AlGaN. Selon l'invention, toute autre couche semiconductrice peut être disposée sur la couche 16 de GaN non intentionnellement dopée, si elle est adaptée pour générer un gaz d'électrons à leur interface. La couche 17 peut par exemple être un autre alliage ternaire de nitrure d'élément III. La couche 17 peut aussi être un alliage binaire de nitrure d'élément III, par exemple du AlN.

Dans l'exemple l'AlGaN de la couche 17 peut comprendre une fraction molaire d'AlN comprise entre 15 et 25% mais d'autres proportions peuvent bien entendu être utilisées.

Le dopage de la couche 14 dopée P est réalisé avec du Magnésium, matériau qui peut aisément être intégré dans la couche 14 lors d'une éventuelle formation par épitaxie. En outre, le Magnésium peut aisément être activé (c'est-à-dire jouer sa fonction d'accepteur). Avantageusement, le dopage de la couche 15 dopée N est réalisé avec du Silicium, matériau qui peut aisément être intégré dans la couche 15 lors d'une éventuelle formation par épitaxie.

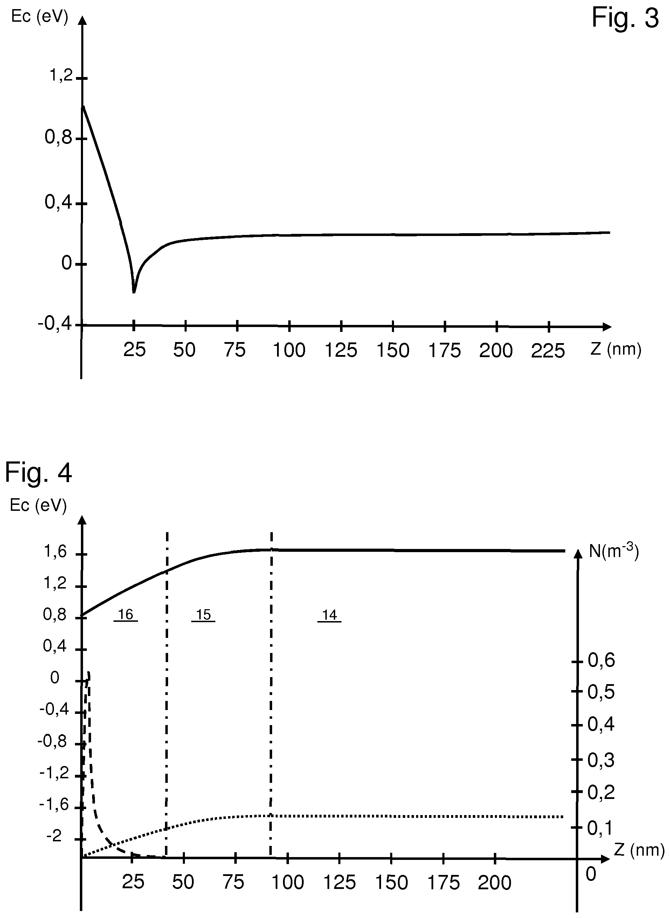

La figure 2 est un diagramme de bande de conduction du transistor 1 détaillé auparavant en fonction de la profondeur, au niveau des accès. À titre de comparaison, la figure 3 fournit un diagramme de bande de conduction d'un transistor de l'état de la technique en fonction de la profondeur au niveau des accès. Le transistor de l'état de la technique pris en compte comporte une couche d'AlGaN de 25 nm formée sur une couche de GaN non intentionnellement dopée d'une épaisseur de 1,40 $\mu$m.

On constate que la barrière de potentiel pour le transistor 1 selon l'invention est typiquement au moins égale à 1,3 eV et au-delà, suivant les concentrations de dopages p et n choisies. A contrario, la barrière de potentiel du transistor selon l'état de la technique est d'environ 0,15 eV. Le transistor 1 selon l'invention permet ainsi d'obtenir une barrière de potentiel particulièrement élevée pour éviter l'injection et par conséquent le piégeage des électrons de la couche de gaz d'électrons 18 dans la couche 13 par exemple. Des simulations ont permis de déterminer que la densité d'électrons dans les couches de gaz d'électrons respectives de ces transistors sont sensiblement équivalentes, d'environ 8,5 * 10$^{12}$ cm$^{-2}$ pour le transistor de l'exemple de la figure 3 contre environ 8,2 * 10$^{12}$ cm$^{-2}$ pour le transistor de l'exemple de la figure 2. La densité d'électrons de la couche de gaz d'électrons 18 selon l'invention reste donc particulièrement élevée.

L'influence de différents paramètres des couches 14, 15 et 16 sur la formation d'une barrière de potentiel pour la couche de gaz d'électrons 18 et la couche de GaN 16 sera davantage détaillée par la suite.

Pour permettre d'anticiper l'influence de différents paramètres sur les performances du transistor 1 selon l'invention, les notations suivantes vont être utilisées par la suite :

Ns : la densité d'électrons dans la couche de gaz d'électrons (en cm$^{-2}$);

$\mu_{2DEG}$ : la mobilité des électrons dans la couche de gaz d'électrons (en cm$^2$/Vs) ;

$N_D$ : la densité volumique de donneurs dans la couche de GaN 15 dopée N (en cm$^{-3}$) ;

$N_A$ : la densité volumique d'accepteurs dans la couche de GaN 14 dopée P (en cm$^{-3}$) ;

$N_{A-}$ : la densité volumique d'accepteurs dans une couche épaisse de GaN dopée P suffisamment épaisse pour être non déplétée (en cm$^{-3}$) ;

$N_{D+}$ : la densité volumique de donneurs dans une couche épaisse de GaN dopée N suffisamment épaisse pour être non déplétée (en cm$^{-3}$) ;

ni : la densité de porteurs intrinsèques dans une couche de GaN à température ambiante (en cm$^{-3}$) ;

RT : la température ambiante prise en compte de 298K ;

T : la température du substrat en K ;

Ron : la résistance du transistor 1 à l'état passant ;

Nsc : la densité d'électrons dans le canal du transistor 1 (en cm$^{-2}$);

$\mu$c : la mobilité des électrons dans le canal (en cm$^2$/Vs);

Wn : l'épaisseur de la couche de GaN dopée N sous la grille de commande;

Wnepi : l'épaisseur de la couche de GaN 15 dopée N;

Wnid : l'épaisseur de la couche de GaN 16 non intentionnellement dopée;

Wp : l'épaisseur de la couche de GaN 14 dopée P;

Wt : l'épaisseur de la zone de transition entre la couche de gaz d'électrons 18 et la partie formant un canal dans la couche GaN 16 ;

tox : l'épaisseur de l'isolant de grille ;

Vbi : le potentiel de diffusion (désigné par le terme de potentiel 'built-in' en langue anglaise) de la jonction P/N formée à l'interface entre les couches 14 et 15 ;

Vbbpn : la barrière de potentiel aux bornes de la jonction P/N déplétée ;

Vbbnid : la barrière de potentiel aux bornes de la couche de GaN 16 non intentionnellement dopée ;

Vbb : la barrière de potentiel totale ;

Lg : la longueur de la grille de commande 3 ;

Lgeff : la longueur de la grille de commande 3 augmentée des zones de transition côté source et drain (Lgeff = Lg+ 2Wt) ;

Lds : la distance drain-source du transistor 1 ;

$\varepsilon_0$ : la permittivité du vide ;

$\varepsilon_{sc}$ : la permittivité du GaN ;

$\varepsilon_{ox}$ : la permittivité de l'oxyde ou isolant de grille utilisé ;

k : la constante de Boltzman = 1,3806488 $E^{-23}$ J/K

q : la charge électronique $\approx$ 1,6 $E^{-19}$ C.

On va modéliser le comportement de la jonction entre les couches 14 et 15 en l'absence de différence de potentiel entre la source 21 et la grille de commande 3. Le potentiel de diffusion de la jonction entre les couches 14 et 15 peut se définir comme suit :

$$V_{bi(T)} = \frac{k \cdot T}{q} ln\left(\frac{N_{A(T)}^- \cdot N_{D(T)}^+}{n_i^2(T)}\right)$$

Avec un dopage P réalisé avec du Magnésium, **l'énergie d'ionisation de l'accepteur Mg dans le GaN est d'environ 180meV. L'ionisation est donc partielle** à la température RT. Il faut donc en tenir compte par l'inégalité $N_{A^-} < N_A$ à la température RT.

Avec ni $\approx$ 1.9 $e^{-10}$ cm$^{-3}$ à la température de 298K, Vbi prend des valeurs de 3.1 +/- 0.1 V pour des valeurs utiles de et $N_{A^-}$. Vbi reste peu sensible aux variations de $N_{A^-}$ et $N_{D+}$ en raison du logarithme dans la relation. La tension de seuil Vth du transistor 1 (formule détaillée par la suite) est donc relativement peu sensible à la concentration de dopants dans les couches 14 et 15.

Pour garantir l'absence de conduction dans le canal lorsque la différence de potentiel Vgs entre grille et source est nulle, on fait en sorte que les charges positives développées dans la couche GaN 15 soient insuffisantes pour équilibrer les charges négatives développées dans la couche GaN 14. Cette condition peut notamment être remplie au moyen d'une couche GaN 15 relativement peu épaisse.

Cette condition peut par exemple s'exprimer par l'inégalité suivante, avec Wn0, l'épaisseur de GaN à dopage N pouvant être déplétée par la couche de GaN 14 à dopage P.

$$W_n < W_{n0} = \sqrt{\frac{2\varepsilon_s \cdot V_{bi} \cdot N_A}{q \cdot N_D \cdot (N_A + N_D)}}$$

Le diagramme de la figure 4 illustre en trait plein la bande de conduction du transistor 1 détaillé auparavant en fonction de la profondeur, au niveau du canal et sous la grille 3. Le diagramme de la figure 4 illustre également en pointillés la bande de valence en fonction de la profondeur sous la grille 3. La figure 4 illustre également en trait discontinu **la densité d'électrons** en fonction de **la profondeur sous la grille, en l'absence de différence de potentiel Vgs.** La **densité d'électrons sous la grille 3** est ainsi extrêmement réduite (au maximum de 5,5 $e^{-6}$cm$^{-2}$).

Par application d'une différence de potentiel Vgs supérieure à Vth, on peut obtenir un canal conducteur par apparition d'une couche d'accumulation d'électrons dans la couche 15 sous l'isolant de grille 32.

La tension de seuil Vth peut se calculer par la formule suivante :

$$V_{th} = \varphi_{MS} + \left(\frac{\varepsilon_s}{\varepsilon_{ox}} \cdot \frac{V_{bi}}{W_n} - \frac{q \cdot N_d \cdot W_n}{2\varepsilon_0 \cdot \varepsilon_{ox}}\right) \cdot t_{ox} \approx \varphi_{MS} + V_{bi}\left(\frac{\frac{t_{ox}}{\varepsilon_{ox}}}{\frac{W_n}{\varepsilon_s}}\right)$$

Avec $\varphi_{MS}$ la différence de travail de sortie entre la couche de GaN 15 et le matériau conducteur de grille 31, **d'une valeur d'environ 1eV dans le cas présent.** Cette contribution $\varphi_{MS}$ **à la tension de seuil peut s'exprimer comme la déplétion** par la grille.

Le second terme correspond à l'effet du potentiel de diffusion Vbi sur la jonction P/N. Le troisième terme correspond à la charge d'espace positive développée dans la couche 15 sous la grille 3.

On conçoit par ailleurs que la tension de seuil Vth est d'autant plus élevée que la valeur Wn (épaisseur de la couche 15 sous la grille 3) est faible. Avec Wn<< Wn0, le troisième terme devient quasiment négligeable par rapport au second terme.

On voit aussi que dans la formule de Vth approximée, le coefficient de pondération du Vbi est le rapport des épaisseurs effectives de l'oxyde et de la couche n 15.

Dans le cas particulier du $Al_2O_3$ choisi comme isolant de grille 32, avec **tox≥Wn, on obtient un décalage de tension de seuil d'au moins 3,1V. Donc Vth$\geq\varphi_{MS}$ + 3,1V**

Par conséquent, on peut aisément obtenir une valeur Vth supérieure à 3V. La valeur de Vth peut aisément être ajustée industriellement en choisissant par exemple des valeurs appropriées de Wn et tox.

Les zones d'accès au canal côté source et drain sont formées par la couche de gaz d'électron 18 et présentent une résistance à l'état passant réduite. La concentration et surtout la mobilité effective des électrons dans le canal lorsque Vgs > Vth restent inférieures à celles des électrons dans la couche de gaz d'électrons 18 au niveau des accès. Par conséquent, pour réduire autant que possible la résistance Ron du transistor à l'état passant, il est souhaitable de réduire la longueur de grille autant que possible par rapport à la distance drain-source Lds. Par exemple, pour des applications où Lds est de l'ordre de $20\mu m$, il est souhaitable d'utiliser une longueur de grille Lg inférieure à $1\mu m$.

Pour calculer la résistance à l'état passant du transistor, on prend en compte une longueur de grille effective Lgeff, définie approximativement comme la longueur Lg de la grille de commande 3 augmentée des zones de transition côté source et drain, soit **Lgeff ≈ Lg+ 2Wt.** La longueur de grille Lg sera moins contrainte pour des applications à haute tension (par exemple des tensions supérieures à 600V).

Pour conserver une résistance de canal faible à l'état passant, on respectera de préférence la relation suivante :

$$L_{g\,eff} \ll \frac{N_{sc}.\mu_c.L_{ds}}{N_s.\mu_{2DEG}}$$

Pour des valeurs courantes de Nsc et $\mu$c, on peut déduire la condition Lgeff < $1\mu m$ et donc Lg < $0,8\mu m$. On pourra par exemple choisir une valeur Lg comprise entre 0,25 et $0,5\mu m$. On conserve de préférence une valeur Lg au moins égale à 0,25, tox devant être suffisamment élevée pour conserver une plage de variation de Vgs de +/-15V ou +/-20V, similaire à ce qui est obtenu avec une grille pour un transistor de type Silicium.

Au niveau des accès, la capacité à tenir la tension en mode bloqué est élevée, grâce au champ électrique critique élevé du matériau du GaN.

**La barrière de potentiel formée entre la couche de gaz d'électrons 18 et la couche tampon 13 (empêchant l'injection et le piégeage des électrons dans les** couches profondes de la couche tampon 13) atteint un niveau élevé et apparaît grâce au potentiel de diffusion Vbi, et inclut :

- en partie une barrière de potentiel aux bornes de la jonction P/N déplétée formée entre les couches 14 et 15 :

$$V_{bbpn} = \frac{q}{2\varepsilon_s}\left(N_A.W_p^2 + 2N_A.W_p.W_n - N_D.W_n^2\right)$$

- en partie une barrière de potentiel aux bornes de la couche GaN 16 :

$$V_{bbnid} = \frac{q}{\varepsilon_s}\left(N_A.W_p - N_D.W_n\right).W_{nid}$$

Dans la zone de charge d'espace de la jonction p/n, toutes les accepteurs et donneurs sont ionisés et c'est donc leur concentration totale qui intervient dans les calculs (cad $N_A$ et $N_D$).

Avec Wnepi =80nm et Wp = 50nm et $N_A$ = $1e^{17}cm^{-3}$, on obtient une barrière de potentiel d'environ 1,3eV dont 0,9eV aux bornes de la jonction et 0,3eV aux bornes de la couche 16.

La barrière de potentiel obtenue par la combinaison des couches 14 et 15 atteint un niveau plus élevé que celui d'une éventuelle couche d'AlGaN qui serait placée sous la couche 16 de formation du gaz d'électrons (comme l'exemple détaillé dans 'Characteristics of AlGaN/GaN/AlGaN double heterojunction HEMTs with an improved breakdown voltage' cité en introduction).

On fournit par la suite des exemples de règles de conception d'un tel transistor 1.

Lorsque le dopant de la couche 14 est du Magnésium, les limites extrêmes pour $N_A$ sont fixée par :

- les capacités de la technologie d'épitaxie à incorporer et activer le Magnésium dans la couche 14 de GaN (en prenant en compte une limite de solubilité et la passivation par des complexes de type Mg-H notamment). La valeur maximale utilisable pour $N_A$ est à ce jour a priori de $1e^{19} cm^{-3}$

- La valeur nécessaire pour avoir un Vbi>3V, soit $N_A > 3e^{16} cm^{-3}$

On peut théoriquement concevoir un transistor 1 selon l'invention dans cette plage de valeurs. En pratique, on utilisera avantageusement une concentration $1e^{17} cm^{-3} < N_A < 1e^{18} cm^{-3}$. $N_A > 1e^{17} cm^{-3}$ permet d'obtenir une barrière de potentiel enterrée (Back Barrier en langue anglaise) significative (>1.3V) et $N_A < 1e^{18} cm^{-3}$ permet d'obtenir une épaisseur robuste pour la couche p 14 (Wp>15nm).

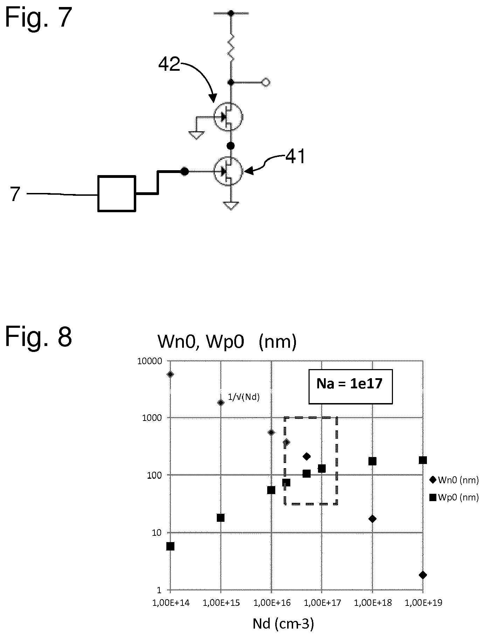

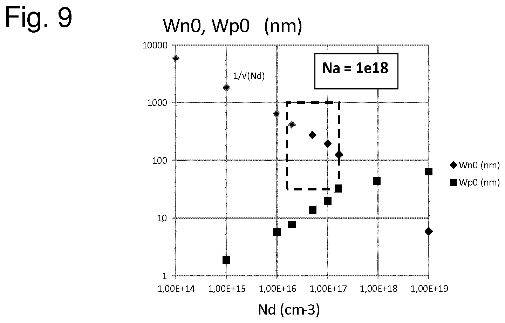

Pour la couche 15, on peut sélectionner par exemple une valeur $N_D$ comprise entre $2e^{16} cm^{-3}$ (pour NA=$1e^{17} cm^{-3}$) et $2e^{17} cm^{-3}$ (pour NA=$1e^{18} cm^{-3}$). La valeur maximale de $N_D$ est par exemple limitée par la perte de mobilité des électrons du canal qui détériorerait alors Ron, en particulier si $N_D > 2e^{17} cm^{-3}$. La valeur minimale de $N_D$ est déterminée par la valeur de $N_A$ : Plus $N_A$ est grand, plus $N_D$ doit être grand, sinon Wp0 (et donc Wp) est trop faible pour permettre la formation de la couche p-GaN 14. Les courbes Wp0 et Wn0 en fonction de $N_D$ pour les valeurs extrêmes de $N_A$ synthétisent cet aspect (comme illustré aux figures 8 et 9). Une fois $N_A$ choisi, la zone en pointillé délimite les possibilités pour $N_D$.

Exemple1 : si NA =$1^e17$ on peut choisir ND entre $2^e16$ et $1^e17$. On choisira $2^e16$ si on veut privilégier la mobilité dans le canal.
Exemple 2 : si NA =$1^e18$ on peut choisir ND =$2^e17$ pour éviter une valeur de Wp trop petite.

La valeur minimale de $N_D$ est aussi définie par la capacité de réalisation de faibles dopages de type N dans du GaN, et par la diminution de la valeur $\varphi_{MS}$ (et donc de la valeur Vth) si Nd est trop faible. Donc, de préférence, $N_D \geq 2e^{16} cm^{-3}$.

On peut ensuite calculer le potentiel de diffusion Vbi selon la relation détaillée précédemment. On peut alors calculer une épaisseur correspondante Wn0 de déplétion totale dans une couche GaN-n 15 de dopage $N_D$ (par exemple 375 nm avec des paramètres détaillés auparavant) et une épaisseur correspondante Wp0 de déplétion totale dans une couche GaN-p 14 (par exemple 75nm avec des paramètres détaillés auparavant et la relation suivante).

$$W_{p0} = \sqrt{\frac{2\varepsilon_s . V_{bi} . N_D^+}{q . N_A^- . (N_A^- + N_D^+)}}$$

On peut ensuite déterminer les épaisseurs du canal et des couches GaN 15 et GaN 14 à réaliser pour que ceux-ci soient complètement déplétés, en respectant seulement les inégalités suivantes :

$$Wn0 \geq Wnepi ;$$

$$Wn0 > Wn ;$$

et

$$Wp0 > Wp$$

La couche de GaN 14 est avantageusement complètement déplétée, pour éviter de conserver une couche conductrice de trous qui empêcherait le champ électrique de se développer dans l'épaisseur de la couche de GaN 13, ce qui induirait une forte dégradation de la tenue en tension du transistor.

Avec Vbi = 3V, $N_A = 1 * 10^{17}$ cm$^{-3}$ et $N_D = 2 * 10^{16}$ cm$^{-3}$, on obtient une valeur de $W_{p0}$ de 75nm. On utilise avantageusement une valeur $W_p$ suffisamment élevée pour pouvoir être réalisée par épitaxie avec robustesse (par exemple $W_p$ > 15nm). Une diminution de la valeur $W_p$ abaisse le niveau de la barrière de potentiel. Par contre, une diminution de la valeur $W_p$ garantit la déplétion de la couche de GaN 14. Avantageusement, $W_p$ est compris entre 30 et 50nm, et de préférence égal à 50nm.

Au niveau des accès, l'épaisseur de la couche de GaN 15 est définie comme Wnepi. Les règles de dimensionnement suivantes visent à dépléter complètement la couche de GaN 15, que ce soit au niveau des accès ou du canal. Par simplification, on pourra considérer que l'épaisseur de la couche de GaN 15 correspond à son épaisseur au niveau des accès.

Avantageusement, Wnepi $\geq$ 0,2 * Wn0 ou Wnepi $\geq$ 75nm, afin d'éviter que la déplétion n'ait un impact sur la couche de gaz d'électrons 18. En effet, la couche 15 doit absorber une proportion non négligeable du potentiel de diffusion Vbi. Une épaisseur Wnepi suffisamment élevée est en outre utilisée pour que la barrière de potentiel générée par la jonction soit suffisante pour empêcher l'injection d'électrons avec une charge d'espace suffisante développée dans la couche 15. Par ailleurs, pour permettre une gravure de la cavité de la grille 3 dans la couche 15 avec suffisamment de marge, on vérifie de préférence l'inégalité Wnepi > Wn + 20nm. Une valeur Wnepi de 80 nm est par exemple satisfaisante.

Par ailleurs, il est souhaitable de limiter la résistance des zones de transition entre la couche de gaz d'électrons 18 et le canal. Pour éviter d'augmenter la longueur de grille effective, l'épaisseur Wnepi est avantageusement minimisée.

Avantageusement, Wn est très inférieur à Wn0 (par exemple Wn0 = 4* Wn), de sorte que le canal dans la couche de GaN 15 soit complètement déplété sous les électrodes du transistor 1 et de sorte que la tension de seuil Vth détaillée auparavant ne soit pas dégradée. Par exemple, pour une valeur Wn0 de 373nm, on peut choisir une valeur Wn inférieure à 93nm. Par ailleurs, si les permittivités de l'isolant 32 et du GaN sont proches, pour obtenir un Vth élevé, il est souhaitable de respecter la relation 50nm ≥ tox ≥ Wn. Par exemple, on peut choisir la valeur Wn entre 20 et 50nm. Une valeur de 40nm s'avère par exemple appropriée. La valeur minimale de Wn est par exemple définie par des contraintes de procédé de fabrication. Ainsi, pour graver la couche 17 d'AlGaN, la couche 16 de GaN et une partie de la couche 15 de GaN, il faut envisager une gravure d'environ 150nm pour ménager la cavité de la grille 3. En l'absence de couche d'arrêt, il est préférable de conserver un canal d'une épaisseur Wn d'au moins 20 nm pour tenir compte de l'imprécision sur la profondeur de la gravure. La valeur minimale de Wn est également fixée par la valeur maximale de Vth. Comme Vth est dépendant du rapport tox/Wn, avec une valeur maximale de Vth de 6V et une valeur plafonnée de tox, on en déduit que Wn doit par exemple être au moins égal à 20nm.

La profondeur d'implantation Wt de la grille 3 dans la couche 15 est de préférence non nulle, avantageusement d'au moins 20nm, voire d'au moins 30nm. Une profondeur d'implantation de 40 nm s'avère par exemple appropriée.

Pour une valeur de Vth souhaitée, en ayant défini les valeurs Wn et $\varphi_{MS}$, on peut déduire la valeur tox pour la couche d'isolant 32, à partir de la relation fournie précédemment pour Vth.

L'épaisseur de la couche 16 est avantageusement suffisamment épaisse pour éviter toute perturbation de la couche de gaz d'électrons 18 au niveau des électrodes du transistor 1 par l'influence chimique (le dépôt de la couche dopée au Magnésium induisant un effet mémoire du Magnésium dans les couches déposées par la suite par épitaxie) et électrique des dopants des couches 14 et 15. Ainsi, avantageusement, 60 nm ≥ Wnid ≥ 20nm (par exemple obtenu avec Wnepi=80nm et Wnepi+Wnid ≥ 100nm pour limiter l'influence du magnésium sur la couche de gaz d'électrons 18). Pour limiter la résistivité des zones de transition entre le gaz d'électrons 18 et le canal, avantageusement, on respecte l'inégalité 100nm > Wnepi -Wn +Wnid.

Avantageusement, Wnid = 50nm.

Les couches 12 à 18 peuvent être formées successivement dans une même machine d'épitaxie en phase vapeur (MOCVD), en changeant bien entendu les conditions d'épitaxie pour chacune des couches. Les paramètres d'épitaxie pour la formation de chacune des couches sont connus en soi de l'homme du métier.

L'épaisseur tox peut être limitée par le procédé de fabrication de l'isolant 32. Par exemple, une couche **d'Al**$_2$O$_3$ déposée par une technique ALD (pour Atomic Layer Deposition en langue anglaise) est délicate à réaliser sur une épaisseur dépassant 50nm. L'épaisseur tox minimale est imposée par la tenue en tension de la grille 3 à l'état passant et à l'état bloqué. Pour un isolant 32 en Al$_2$O$_3$, une épaisseur tox au moins égale à 40nm peut s'avérer nécessaire pour des tensions au moins égales à 600V et une plage de variation de Vgs de +/-20V. Une valeur tox de 40 nm s'avère généralement appropriée pour de l'Al$_2$O$_3$. D'autres matériaux pour l'isolant de grille 92 peuvent être utilisés, par exemple (et non limitativement) du SiN, du SiO2, du AIN, un AlO$_x$N ou du HfO$_2$.

Pour obtenir une valeur de Vth maximale, on peut utiliser un métal comme matériau conducteur 31 présentant un travail de sortie élevé, par exemple du Ni. D'autres métaux compatibles avec les technologies CMOS peuvent également être utilisés, dont des exemples non exhaustifs sont le W, le Ti, le polysilicium dopé P+ ou le TiN. On peut également envisager une grille en diamant p+ avec un contact ohmique sur le diamant réalisé à partir de Ti recuit, pour obtenir une valeur $\varphi_{MS}$ particulièrement élevée.

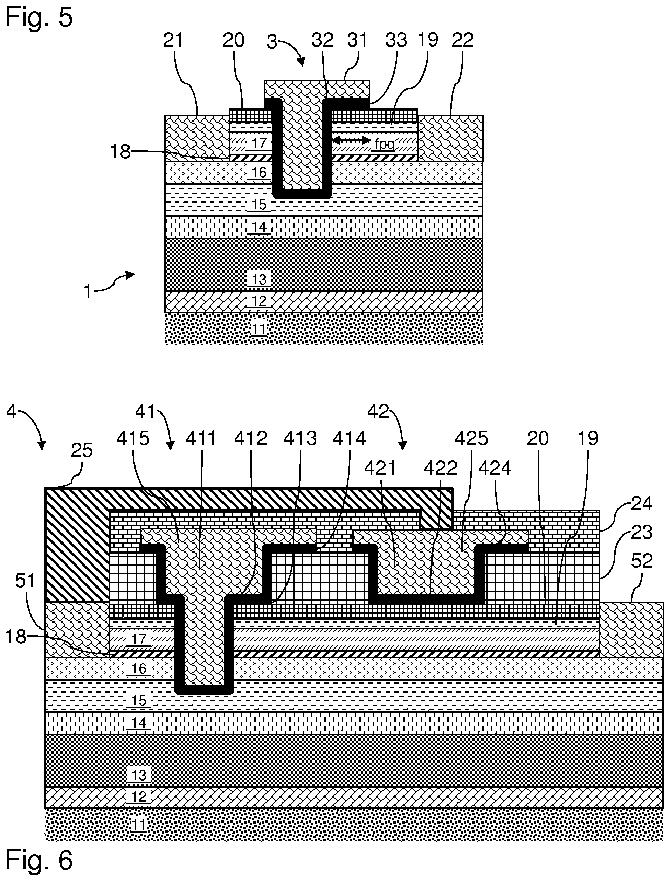

La figure 5 est une vue en coupe schématique d'une variante de transistor 1 destinée à accroître sa tenue en tension. Cette variante s'avère particulièrement appropriée lorsque la longueur de grille est réduite, par exemple inférieure à 0,5μm. Cette variante inclut une grille de commande 3 comprenant une électrode de champ ou FPG (pour Field Plate Gate).

La grille 3 du transistor 1 comporte ici un débordement latéral 33 au-dessus de la couche 17 (et en l'occurrence au-dessus des couches 19 et 20). Ce débordement latéral s'étend d'environ une longueur fpg par rapport à la cavité de la grille 3. Ainsi, le matériau conducteur de grille 31 et l'isolant de grille 32 s'étendent latéralement d'une longueur fpg par rapport à la cavité de la grille 3. La géométrie de l'électrode de champ est avantageusement optimisée (longueur, hauteur) de façon connue en soi de l'homme du métier afin de réduire le pic de champ électrique au pied de la grille.

La figure 6 est une vue en coupe schématique d'une structure cascode 4 incluant un transistor de type normalement bloqué selon l'invention. La figure 7 est un schéma électrique équivalent de cette structure cascode 4. Une telle structure s'avère également particulièrement appropriée pour un transistor de type normalement bloqué dont la longueur de grille est réduite dans la cavité traversant la couche de gaz électrons, par exemple inférieure à 0,2 μm. Une telle structure cascode 4 permet d'accroître la tenue en tension malgré l'utilisation d'un transistor normalement bloqué à grille courte.

La structure cascode 4 inclut des transistors 41 et 42 à heterojonction à haute mobilité électronique connectés en série. Le transistor 41 est de type normalement bloqué, le transistor 42 étant de type normalement passant. La grille de commande 415 du transistor 41 est pilotée de façon connue en soi par un circuit de commande 7, par l'intermédiaire d'une connexion non illustrée à la figure 6. La source 51 du transistor 41 est connectée à la grille de commande 425 du transistor 42. Le drain 52 du transistor 42 constitue une électrode de sortie de la structure cascode 4.

La couche 20 est recouverte d'une couche d'isolant 23. Cette couche 23 est par exemple réalisée en oxyde de silicium et peut par exemple présenter une épaisseur d'environ 400 nm.

La grille de commande 415 est notamment formée dans une cavité traversant les couches 16 et 17, et s'étendant jusque dans la couche 15. La cavité est recouverte d'une couche d'isolant 412 et remplie par un matériau conducteur de grille 411. La grille 415 traverse par ailleurs la couche d'isolant 23.

La grille 415 du transistor 41 comporte ici un débordement latéral 413 au-dessus de la couche 17 (et en l'occurrence au-dessus des couches 19 et 20). La grille de commande 415 comprend ainsi une électrode de champ ou FPG (pour Field Plate Gate). Ce débordement latéral 413 s'étend d'environ une longueur fpg par rapport à la cavité de la grille 415. Ainsi, le matériau conducteur de grille 411 et l'isolant de grille 412 s'étendent latéralement d'une longueur fpg par rapport à la cavité de la grille 415. La géométrie de l'électrode de champ est avantageusement optimisée (longueur, hauteur) de façon connue en soi de l'homme du métier afin de réduire le pic de champ électrique au pied de la grille. Comme dans l'exemple illustré à la figure 5, le matériau conducteur de grille 411 et l'isolant de grille 412 s'étendent latéralement par rapport à la cavité de la grille 415.

La grille 415 comporte en outre un débordement latéral 414 au-dessus de la couche 23. Le matériau conducteur 411 et l'isolant 412 s'étendent latéralement par rapport au débordement 413.

La grille de commande 425 est formée dans une cavité traversant la couche 23 et s'étendant jusqu'à la couche 20. La cavité est recouverte d'une couche d'isolant 422 et remplie par un matériau conducteur de grille 421. La combinaison de l'isolant de grille 422 et de la couche 20 présente ici un fond en contact avec la couche 19. La grille 425 comporte un débordement latéral 424 au-dessus de la couche 23. Le matériau conducteur 421 et l'isolant 422 s'étendent latéralement par rapport à la cavité de la grille 425. Les grilles 415 et 425 sont ici recouvertes d'une couche d'isolant 24. Cette couche d'isolant 24 présente par exemple une épaisseur de 200 nm et peut par exemple être réalisée en oxyde de silicium. Du métal d'interconnexion 25 connecte ici la grille de commande 425 à la source 51.

Les grilles 415 et 425 sont réalisées sans étape supplémentaire dans le procédé de fabrication du transistor 1, ce qui est intéressant pour son coût de fabrication.

Le drain du transistor 41 et la source du transistor 42 sont avantageusement confondus, leur connexion étant réalisée dans la couche de gaz d'électrons 18. La structure cascode 4 obtenue est ainsi particulièrement compacte et présente une résistance à l'état passant relativement réduite. Le drain du transistor 41 et la source du transistor 42 forment un **nœud** flottant.

**Revendications**

1. Transistor à effet de champ (1) à haute mobilité électronique de type normalement bloqué, **caractérisé en ce qu'**il comprend :

   - une première couche de GaN (14) à dopage de type P, incluant du Magnésium formant un dopant de type P, la concentration en dopants de type P dans la première couche de GaN (14) étant au moins égale à $1 * 10^{17}$ cm$^{-3}$ et au plus égale à $1 * 10^{18}$ cm$^{-3}$, la concentration en magnésium activé dans la première couche de GaN (14) est au moins égale à $1 * 10^{17}$ cm$^{-3}$ et au plus égale à $1 * 10^{18}$ cm$^{-3}$, ladite première couche de GaN (14) présentant une épaisseur comprise entre 10 et 50 nm ;
   - une deuxième couche de GaN (15) à dopage de type N formée sur la première couche de GaN de façon à former une jonction p/n complètement déplétée, la deuxième couche de GaN (15) présentant une épaisseur Wne-pi<Wn0, avec :

$$W_{n0} = \sqrt{\frac{2\varepsilon_s . V_{bi}. N_A}{q . N_D.(N_A + N_D)}}$$

Avec

$N_D$: la densité volumique de donneurs dans la deuxième couche de GaN;

$N_A$: la densité volumique d'accepteurs dans la première couche de GaN;

Vbi : le potentiel de diffusion de la jonction P/N formée à l'interface entre les première et deuxième couches de GaN ;

$\varepsilon_s$ : la permittivité du GaN

- une troisième couche de GaN (16) non intentionnellement dopée et formée sur la deuxième couche de GaN ;
- une couche semi conductrice (17) formée à l'aplomb de la troisième couche de GaN non intentionnellement dopée pour former une couche de gaz d'électrons (18) à l'interface entre cette couche semi conductrice (17) et la troisième couche de GaN (16) ;
- une cavité ménagée à travers ladite troisième couche de GaN et à travers la couche semi-conductrice (17), et s'étendant jusqu'à la deuxième couche de GaN (15) sans atteindre le fond de cette deuxième couche de GaN ;
- une grille (3) incluant un matériau de grille conducteur (31) et une couche d'isolant de grille (32) disposés dans ladite cavité, ladite couche d'isolant de grille isolant électriquement ledit matériau de grille conducteur (31) par rapport auxdites deuxième et troisième couches de GaN et par rapport à la couche semi-conductrice (17).

2. Transistor à effet de champ (1) à haute mobilité électronique selon la revendication 1, dans lequel ladite première couche de GaN (14) est formée sur une quatrième couche de GaN (13) présentant une concentration en carbone supérieure à celle des première et deuxième couches (14, 15) de GaN.

3. Transistor à hétérojonction selon l'une quelconque des revendications précédentes, dans lequel la deuxième couche de GaN (15) inclut du Silicium formant un dopant de type N.

4. Transistor à hétérojonction selon la revendication 3, dans lequel la concentration en Silicium dans la deuxième couche de GaN (15) est au moins égale à $2 * 10^{16}$ cm$^{-3}$ et/ou au maximum égale à $2 * 10^{17}$ cm$^{-3}$.

5. Transistor à hétérojonction selon l'une quelconque des revendications précédentes, dans lequel ladite deuxième couche de GaN (15) présente une épaisseur comprise entre 50 et 100 nm.

6. Transistor à hétérojonction selon l'une quelconque des revendications précédentes, dans lequel la concentration en dopants de type N dans la deuxième couche de GaN (15) est inférieure à la concentration en dopants de type P dans la première couche de GaN (14).

7. Transistor à hétérojonction selon l'une quelconque des revendications précédentes, dans lequel ladite troisième couche (16) comporte une concentration en dopants au moins deux fois inférieure à la concentration en dopants de la deuxième couche de GaN (15).

8. Transistor à hétérojonction selon l'une quelconque des revendications précédentes, dans lequel ladite troisième couche (16) présente une épaisseur comprise entre 20 et 60nm.

9. Transistor à hétérojonction selon l'une quelconque des revendications précédentes, dans lequel ladite couche d'isolant de grille (32) présente une épaisseur au moins égale à 20nm.

10. Transistor à hétérojonction selon l'une quelconque des revendications précédentes, dans lequel ladite cavité s'étend dans la deuxième couche de GaN (15) sur une profondeur d'au moins 20nm.

11. Transistor à hétérojonction selon la revendication 10, dans lequel l'épaisseur d'un canal ménagé dans la deuxième couche de GaN (15) entre ladite cavité et la première couche de GaN (14) est au moins égale à 20nm.

12. Transistor à hétérojonction (1) selon l'une quelconque des revendications précédentes, dans lequel ladite couche semi conductrice (17) inclut un alliage de type III-N.

13. Transistor à hétérojonction selon l'une quelconque des revendications précédentes, dans lequel ladite grille (3) présente une longueur au plus de $0{,}8\mu$m.

14. Transistor à hétérojonction selon la revendication 13, dans lequel ladite grille (3) présente un débordement (33) par rapport à ladite cavité, le débordement s'étendant à l'aplomb de ladite couche semi conductrice (17).

**Patentansprüche**

1. Selbstsperrender Feldeffekttransistor (1) mit hoher Elektronenbeweglichkeit, **dadurch gekennzeichnet, dass** er umfasst:

   - eine erste p-Typ-dotierte GaN-Schicht (14), die Magnesium beinhaltet, das einen p-Typ-Dotierungsstoff bildet, wobei die Konzentration an p-Typ-Dotierungsstoffen in der ersten GaN-Schicht (14) mindestens $1 * 10^{17}$ cm$^{-3}$ und höchstens $1 * 10^{18}$ cm$^{-3}$ beträgt, wobei die Konzentration an aktiviertem Magnesium in der ersten GaN-Schicht (14) mindestens $1 * 10^{17}$ cm$^{-3}$ und höchstens $1 * 10^{18}$ cm$^{-3}$ beträgt, wobei die erste GaN-Schicht (14) eine Dicke zwischen 10 und 50 nm aufweist;
   - eine zweite n-Typ-dotierte GaN-Schicht (15), die auf der ersten GaN-Schicht gebildet ist, so dass ein vollständig depletierter p/n-Übergang gebildet wird, wobei die zweite GaN-Schicht (15) eine Dicke Wnepi<Wn0 aufweist, mit:

$$W_{n0} = \sqrt{\frac{2\varepsilon_s . V_{bi}. N_A}{q . N_D. (N_A + N_D)}}$$

   Mit

   $N_D$: Volumendichte von Donatoren in der zweiten GaN-Schicht;
   $N_A$: Volumendichte von Akzeptoren in der ersten GaN-Schicht;
   Vbi: Diffusionspotential des p/n-Übergangs, der an der Grenzfläche zwischen der ersten und der zweiten GaN-Schicht gebildet wird;
   $\varepsilon_s$: Permittivität des GaN

   - eine dritte GaN-Schicht (16), die nicht absichtlich dotiert ist und auf der zweiten GaN-Schicht gebildet ist;
   - eine Halbleiterschicht (17), die lotrecht zu der nicht absichtlich dotierten dritten GaN-Schicht gebildet ist, um eine Elektronengasschicht (18) an der Grenzfläche zwischen dieser Halbleiterschicht (17) und der dritten GaN-Schicht (16) zu bilden;
   - eine Kavität, die durch die dritte GaN-Schicht hindurch und durch die Halbleiterschicht (17) hindurch ausgebildet ist und sich bis zu der zweiten GaN-Schicht (15) erstreckt, ohne den Boden dieser zweiten GaN-Schicht zu erreichen;
   - ein Gate (3), das ein leitendes Gate-Material (31) und eine Gate-Isolatorschicht (32) beinhaltet, die in der Kavität angeordnet sind, wobei die Gate-Isolatorschicht das leitende Gate-Material (31) in Bezug auf die zweite und die dritte GaN-Schicht und in Bezug auf die Halbleiterschicht (17) isoliert.

2. Feldeffekttransistor (1) mit hoher Elektronenbeweglichkeit nach Anspruch 1, wobei die erste GaN-Schicht (14) auf einer vierten GaN-Schicht (13) gebildet ist, die eine höhere Kohlenstoffkonzentration als die erste und die zweite GaN-Schicht (14, 15) aufweist.

3. Transistor mit Heteroübergang nach einem der vorhergehenden Ansprüche, wobei die zweite GaN-Schicht (15) Silicium beinhaltet, das einen n-Typ-Dotierungsstoff bildet.

4. Transistor mit Heteroübergang nach Anspruch 3, wobei die Siliciumkonzentration in der zweiten GaN-Schicht (15) mindestens $2 * 10^{16}$ cm$^{-3}$ und/oder höchstens $2 * 10^{17}$ cm$^{-3}$ beträgt.

5. Transistor mit Heteroübergang nach einem der vorhergehenden Ansprüche, wobei die zweite GaN-Schicht (15) eine Dicke zwischen 50 und 100 nm aufweist.

6. Transistor mit Heteroübergang nach einem der vorhergehenden Ansprüche, wobei die Konzentration an n-Typ-Dotierungsstoffen in der zweiten GaN-Schicht (15) geringer als die Konzentration an p-Typ-Dotierungsstoffen in der ersten GaN-Schicht (14) ist.

7. Transistor mit Heteroübergang nach einem der vorhergehenden Ansprüche, wobei die dritte Schicht (16) eine Konzentration an Dotierungsstoffen beinhaltet, die mindestens zwei Mal geringer als die Konzentration an Dotierungsstoffen der zweiten GaN-Schicht (15) ist.

8. Transistor mit Heteroübergang nach einem der vorhergehenden Ansprüche, wobei die dritte Schicht (16) eine Dicke zwischen 20 und 60 nm aufweist.

9. Transistor mit Heteroübergang nach einem der vorhergehenden Ansprüche, wobei die Gate-Isolatorschicht (32) eine Dicke von mindestens 20 nm aufweist.

10. Transistor mit Heteroübergang nach einem der vorhergehenden Ansprüche, wobei sich die Kavität in der zweiten GaN-Schicht (15) über eine Tiefe von mindestens 20 nm erstreckt.

11. Transistor mit Heteroübergang nach Anspruch 10, wobei die Dicke eines Kanals, der in der zweiten GaN-Schicht (15) zwischen der Kavität und der ersten GaN-Schicht (14) ausgebildet ist, mindestens 20 nm beträgt.

12. Transistor mit Heteroübergang (1) nach einem der vorhergehenden Ansprüche, wobei die Halbleiterschicht (17) eine III-N-Legierung beinhaltet.

13. Transistor mit Heteroübergang nach einem der vorhergehenden Ansprüche, wobei das Gate (3) eine Länge von höchstens 0,8 $\mu$m aufweist.

14. Transistor mit Heteroübergang nach Anspruch 13, wobei das Gate (3) einen Überstand (33) in Bezug auf die Kavität aufweist, wobei sich der Überstand lotrecht zu der Halbleiterschicht (17) erstreckt.


**Claims**

1. High-electron-mobility field-effect transistor (1) of normally-off type, **characterized in that** it comprises:

   - a first layer of GaN (14) with P-type doping, including magnesium forming a P-type dopant, the concentration of P-type dopants in the first layer of GaN (14) being at least equal to $1 \times 10^{17}$ cm$^{-3}$ and at most equal to $1 \times 10^{18}$ cm$^{-3}$, the concentration of activated magnesium in the first layer of GaN (14) is at least equal to $1 \times 10^{17}$ cm$^{-3}$ and at most equal to $1 \times 10^{18}$ cm$^{-3}$, said first layer of GaN (14) having a thickness of between 10 and 50 nm;
   - a second layer of GaN (15) with N-type doping formed on the first layer of GaN so as to form a completely depleted p/n junction, the second layer of GaN (15) having a thickness Wnepi<Wn0, with:

$$W_{n0} = \sqrt{\frac{2\varepsilon_s \cdot V_{bi} \cdot N_A}{q \cdot N_D \cdot (N_A + N_D)}}$$

   with

   $N_D$: the volume density of donors in the second layer of GaN;
   $N_A$: the volume density of acceptors in the first layer of GaN;
   Vbi: the diffusion potential of the P/N junction formed at the interface between the first and second layers of GaN;
   $\varepsilon_s$: the permittivity of the GaN;

   - a third layer of GaN (16) that is not intentionally doped and is formed on the second layer of GaN;
   - a semiconductor layer (17) formed above the third layer of GaN that is not intentionally doped, in order to form an electron gas layer (18) at the interface between this semiconductor layer (17) and the third layer of GaN (16);
   - a cavity formed through said third layer of GaN and through the semiconductor layer (17), and extending to the second layer of GaN (15) without reaching the bottom of this second layer of GaN;
   - a gate (3) including a conductive gate material (31) and a gate insulation layer (32) arranged in said cavity, said gate insulation layer electrically insulating said conductive gate material (31) relative to said second and third layers of GaN and relative to the semiconductor layer (17).

2. High-electron-mobility field-effect transistor (1) according to Claim 1, in which said first layer of GaN (14) is formed on a fourth layer of GaN (13) having a carbon concentration greater than that of the first and second layers (14, 15) of GaN.

3. Heterojunction transistor according to any one of the preceding claims, in which the second layer of GaN (15) includes silicon forming an N-type dopant.

4. Heterojunction transistor according to Claim 3, in which the silicon concentration in the second layer of GaN (15) is at least equal to $2*10^{16}$ cm$^{-3}$ and/or at most equal to $2*10^{17}$ cm$^{-3}$.

5. Heterojunction transistor according to any one of the preceding claims, in which said second layer of GaN (15) has a thickness of between 50 and 100 nm.

6. Heterojunction transistor according to any one of the preceding claims, in which the concentration of N-type dopants in the second layer of GaN (15) is less than the concentration of P-type dopants in the first layer of GaN (14).

7. Heterojunction transistor according to any one of the preceding claims, in which said third layer (16) comprises a concentration of dopants at least two times smaller than the concentration of dopants of the second layer of GaN (15).

8. Heterojunction transistor according to any one of the preceding claims, in which said third layer (16) has a thickness of between 20 and 60 nm.

9. Heterojunction transistor according to any one of the preceding claims, in which said gate insulation layer (32) has a thickness at least equal to 20 nm.

10. Heterojunction transistor according to any one of the preceding claims, in which said cavity extends into the second layer of GaN (15) to a depth of at least 20 nm.

11. Heterojunction transistor according to Claim 10, in which the thickness of a channel formed in the second layer of GaN (15) between said cavity and the first layer of GaN (14) is at least equal to 20 nm.

12. Heterojunction transistor (1) according to any one of the preceding claims, in which said semiconductor layer (17) includes an alloy of III-N type.

13. Heterojunction transistor according to any one of the preceding claims, in which said gate (3) has a length of at most 0.8 $\mu$m.

14. Heterojunction transistor according to Claim 13, in which said gate (3) exhibits an overlap (33) relative to said cavity, the overlap extending directly above said semiconductor layer (17).

## Fig. 1

## Fig. 2

Fig. 3

Fig. 4

Fig. 5

Fig. 6

Fig. 7

Fig. 8

Fig. 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2011068371 A

**Littérature non-brevet citée dans la description**

- **HIROSHI KAMBAYASHI et al.** *Solid-State Electronics*, June 2010, vol. 54 (6), 660-664

- **WANG**. Normally-Off Al2O3/GaN MOSFET on Silicon Substrate based on Wet-Etching. *26ème Symposium International Power Semiconductor Devices & IC*, 15 June 2014, 253-256